# EUROPÄISCHE PATENTSCHRIFT

(11) **EP 2 308 279 B1**
(45) Veröffentlichungstag und Bekanntmachung des Hinweises auf die Patenterteilung: **06.09.2017**
(21) Anmeldenummer: 09772140.1
(22) Anmeldetag: 30.06.2009
(51) Int. Cl.: F24F 11/00, E04H 5/00, E04H 5/02, H05K 7/20

(54) **GEBÄUDE FÜR EIN RECHENZENTRUM MIT EINRICHTUNGEN ZUR EFFIZIENTEN KÜHLUNG**
BUILDING FOR A COMPUTER CENTRE WITH DEVICES FOR EFFICIENT COOLING
BÂTIMENT POUR UN CENTRE DE CALCUL, AVEC ÉQUIPEMENTS POUR UN REFROIDISSEMENT EFFICACE

(30) Priorität: 30.06.2008 DE 102008030308
(43) Veröffentlichungstag der Anmeldung: 13.04.2011
(73) Patentinhaber: Lindenstruth, Volker, Prof., 55128 Mainz (DE)
(72) Erfinder: LINDENSTRUTH, Volker, 55128 Mainz (DE)
(74) Vertreter: Mai Dörr Besier European Patent Attorneys
(86) Internationale Anmeldenummer: PCT/EP2009/004704
(87) Internationale Veröffentlichungsnummer: WO 2010/000440

(56) Entgegenhaltungen:
- WO-A-02/052107
- WO-A-03/083631
- DE-A1-102005 005 588
- US-A1- 2001 042 616
- US-A1- 2004 190 229

## Beschreibung

Die vorliegende Erfindung befasst sich mit der Struktur eines Gebäudes für ein Rechenzentrum, die dazu bestimmt ist, eine Vielzahl von Racks aufzunehmen, welche Raum für Computerhardware bereitstellen. Das Gebäude des Rechenzentrums ist mit Kühlanlagen ausgestattet, um die Abfuhr von Wärme zu gewährleisten, die von der Computerhardware erzeugt wird.

### Hintergrund und Stand der Technik

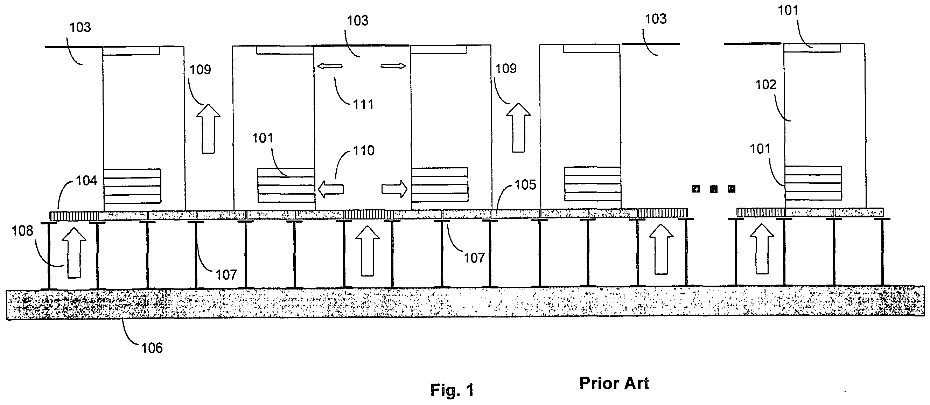

Im Stand der Technik gibt es verschiedene Strukturen von Gebäuden zur Aufnahme einer Vielzahl von Racks, die Raum für Computerhardware bereitstellen. Ein beispielhaftes konventionelles Gebäude für ein Rechenzentrum nach dem Stand der Technik ist in Figur 1 skizziert. Es umfasst einen Doppelboden für eine Computerinfrastruktur, die typischerweise in 19"-Racks untergebracht ist. Die Kühlung erfolgt über Kaltluft, die in den Doppelboden gepumpt wird. Der Doppelboden weist an geeigneten Stellen vor den Racks Lochblenden auf. Dadurch wird den Racks Kaltluft an den Lufteinlässen zugeführt.

Wie in Figur 1 dargestellt, trägt der Boden 106 den Doppelboden, der auf senkrechten Stahlträgern 107 steht; dieser trägt Bodenplatten 104, 105, auf denen wiederum die Computerinfrastruktur steht, zum Beispiel als 19"-Racks 102. In diesen Racks 102 ist üblicherweise 19"-Rack-montierbare Computerinfrastruktur 101 untergebracht, welche horizontal montiert ist und welche Luft von der Vorderseite des Racks bezieht und Warmluft an der Rückseite erzeugt. Um die Computer zu kühlen, haben die Bodenplatten des Doppelbodens geeignete Lüftungslöcher 104, damit Kaltluft 110 von den Racks 102 aufgenommen werden kann.

Im Stand der Technik wird auch ein geschlossener Kaltluftgang 103 bereitgestellt, um zu vermeiden, dass Warmluft 109 die Strömung der Kaltluft kurzschließt. Aufgrund dieses Abschlusses kann die zur Verfügung gestellte Kaltluft 110, 111 den Gang 103 nur über den Lufteinlass der Computer verlassen und dementsprechend gibt es keinen anderen Weg, auf welchem die Warmluft in diesen Bereich gelangen kann.

Dieses Design ist insoweit nachteilig, als dass die einzelnen Racks 102 als geschlossene Racks gestaltet werden müssen. Darüber hinaus muss der Luftstrom durch die jeweiligen Racks 102 überwacht und gesteuert werden, um zu vermeiden, dass unnötige Mengen von Kaltluft aus dem Kaltluft-Gang eingepumpt werden. Es existieren verschiedene Konzepte, die eine Steuerung des Luftstroms im Kaltluft-Gang 102 erlauben, indem Gebläse, welche den Luftstrom 108 erzeugen, mit niedrigst möglicher Leistung arbeiten. Die Warmluft 109, welche auf der Rückseite des Racks 102 erzeugt wird, wird zu nicht explizit dargestellten Wärmetauschern geführt, die an anderer Stelle im Gebäude des Rechenzentrums aufgestellt sind. Die aufgewärmte Luft wird entweder wieder heruntergekühlt oder es wird Frischluft verwendet, um den Kaltluftstrom 108 bereitzustellen.

Diese Architektur hat verschiedene Nachteile. Als erstes wird aufgrund der relativ kleinen Wärmekapazität von Luft eine verhältnismäßig hohe Temperaturdifferenz zwischen der Kaltluft und der Warmluft benötigt. Des Weiteren wird eine große Luftströmungsrate benötigt, welche mit großen Verlusten beim Pumpen der Luft verbunden ist. Vernünftige Grenzen der Luftströmungsrate und der Lufttemperatur begrenzen die Gesamtgröße des Rechenzentrumgebäudes. Darüber hinaus produziert ein Luftkühlungssystem typischerweise 40% Verlustleistung. Weiterhin ist eine Doppelboden-Architektur relativ teuer und vergeudet Volumen im Inneren des Gebäudes.

Das Dokument WO 02/052107 A2 offenbart des Weiteren ein Rechenzentrumgebäude, welches ein Erdgeschoss und in Abständen dazu untere und obere Halbgeschosse zwischen Erdgeschoss und Dach aufweist. Jedes der Halbgeschosse hat eine offene Abdeckung, an der Umgebungsluft vorbeiströmen kann, wobei eine erzwungene Zirkulation der Umgebungsluft vorgeschlagen wird, um das Rechenzentrum auf einer annehmbaren Betriebstemperatur zu halten. Obwohl das hier beschriebene Gebäude durch die Nutzung von industriellen oder Lagerhaus-Strukturen mit Halbgeschoss-Bodenkonstruktionen die Nutzung von Doppelböden vermeidet, ist der Mechanismus der Wärmeableitung noch immer nicht optimal, da eine sehr große Menge von Kaltluft durch das gesamte Gebäude gefördert werden muss, was schwierig zu steuern und ziemlich uneffizient ist.

Auch hier ist die Gesamtgröße des Gebäudes begrenzt, weil zur effizienten Kühlung das gesamte innere Volumen des Gebäudes mit einem ausreichenden Umgebungsluftstrom versorgt werden muss. Darüber hinaus erlaubt diese Architektur nicht mehrere Böden mit großen Wärmequellen wie zum Beispiel Computer Racks, da die Lufttemperatur zu den höher gelegenen Böden hin immer höher und höher werden würde. Der dargestellte Stand der Technik unterstützt lediglich einen einzigen Boden mit verhältnismäßig geringer Leistungsdichte, zum Beispiel um Netzwerk-Komponenten und einen Boden mit einer Computerinfrastruktur zu installieren.

### Aufgabe

Diese Erfindung zielt daher darauf, ein Rechenzentrum bzw. eine Rechenzentrumgebäudestuktur bereitzustellen, welche einen effizienteren und universellen Kühlungsmechanismus für Computerhardwareracks umfasst und die Notwendigkeit einer Rack-übergreifenden Kühlluftführung vermeidet. Weiterhin zielt die Erfindung auf die Optimierung von Energie und Kosten, sowie auf die Bereitstellung einer höheren räumlichen Dichte in der Anordnung der Computerracks, um die erforderliche gesamte Netzwerkkabellänge zu minimieren, womit auch die Kommunikationsleistung verbessert wird. Zusätzlich zielt diese Erfindung auf die Bereitstellung einer Struktur eines Rechenzentrumgebäudes, welches größere, skalierbare Speicherkapazität und ein vergrößertes Speichervolumen als die herkömmlichen Lösungen umfasst.

### Darstellung der Erfindung

Die Aufgabe wird gelöst durch ein Rechenzentrum gemäß Anspruch 1, die Verwendung eines Racks zur Anordnung in einem solchen Rechenzentrum nach dem Anspruch 14 und ein Verfahren zur Kühlung einer Struktur eines Rechenzentrums nach dem Anspruch 15. Die vorliegende Erfindung beschreibt gemäß einem ersten Aspekt die Struktur eines Rechenzentrums bzw. Rechenzentrumgebäudes, welches mindestens einen ersten und einen zweiten Stock bzw. eine erste bzw. zweite Ebene umfasst und welches für die Unterbringung einer Mehrzahl von Racks geeignet ist, von denen jedes einzelne Platz für Computerhardware bietet.

Die Stockwerke bzw. Ebenen sind als Hochregallager ausgebildet. Demzufolge müssen diese und/oder das gesamte Rechenzentrumgebäude nicht notwendig über einen Boden verfügen, sondern Design und Struktur können bodenfrei sein. Die Verwendung eines Hochregallagers ist besonders platzsparend, da auf Böden, insbesondere doppelte Böden verzichtet werden kann. Darüber hinaus lassen sich auf diese Weise die Kosten für ein erfindungsgemäßes Rechenzentrumgebäude reduzieren, da Hochregallager preiswerter angegeben werden können als normale Rechenzentrumgebäudestrukturen.

Das Rechenzentrumgebäude umfasst weiterhin einen ersten Kühlkreislauf, um Wärme abzuführen, welche von der Computerhardware erzeugt wird. Dieser erste Kühlkreislauf ist darauf ausgelegt, alle Racks mit einem Kühlmittel zu versorgen, und der erste Kühlkreislauf ist weiterhin darauf ausgelegt, das von der Computerhardware erwärmte Kühlmittel von allen Racks abzutransportieren.

Die Erfindung ist dadurch gekennzeichnet, dass die vorgenannten Racks, welche mit dem ersten Kühlkreislauf verbunden sind, Wärmetauschereinrichtungen umfassen, die dazu ausgebildet sind, die gesamte von der Computerhardware erzeugte Wärme auf das Kühlmittel zu übertragen. Die Wärmetauschereinrichtungen sind somit erfindungsgemäß derart dimensioniert, dass diese im Betrieb die komplette von der Computerhardware erzeugte Wärmemenge abführen können. Auf diese Weise wird erreicht, dass keine Warmluft an das Rechenzentrum abgegeben wird. Die den Racks zugeführte und die von den Racks abgeführte Luft weist die gleiche oder gar eine niedrigere Temperatur auf, sodass auf eine externe, Rack-übergreifende Luftführung vollständig verzichtet werden kann. Ein Ansteigen der Raumtemperatur in der Vertikalen wird damit verhindert. Insbesondere können die Wärmetauschereinrichtungen sogar überdimensioniert werden, sodass die Wärmetauschereinrichtungen selbst zu einer Kühlung des Rechenzentrums beitragen.

Die vorliegende Erfindung basiert somit auf einer vollständig Rack-spezifischen Kühlung innerhalb eines Hochregallagers und einem Transport, um das Problem zu umgehen, wie ein Strom von Kühlluft durch das gesamte Gebäude bereitgestellt und kontrolliert werden kann. Stattdessen benötigt der erste Kühlkreislauf nur einen beschränkten Platz. Alle Computerhardwareracks sind individuell an den ersten Kühlkreislauf angeschlossen, welcher ein effizientes Instrument zum Transportieren und Ableiten der Wärme von der Computerhardware weg bereitstellt.

Die individuelle Ankoppelung jedes zu kühlenden Racks an den Kühlkreislauf in Verbindung mit Rack-spezifischen Wärmetauschereinrichtungen, die dafür geeignet sind, die gesamte von der Computerhardware erzeugte Wärme an den Kühlkreislauf zu transportieren, hat den weiteren Vorteil, dass Kühlleistung und Wärmeaustausch individuell und separat für jedes einzelne Rack in der Struktur des Rechenzentrumgebäudes kontrolliert und auch überwacht werden können. Das Kühlen der Warmluft ausschließlich innerhalb des Racks erlaubt eine beliebige Packungsdichte von Racks ohne die Notwendigkeit irgendeiner Luftführung.

Die individuelle und separate Kühlinfrastruktur erlaubt eine Anordnung der Racks in einer Hochregallager-Vielebenenstruktur, da die gesamte Umgebungstemperatur des Gebäudes in einem gut definierten, ziemlich niedrigen Temperaturbereich gehalten werden kann. Darüber hinaus erlaubt die vorgeschlagene Kühlung die Verwendung einer sogenannten offenen Rack-Architektur, weswegen die Racks nicht mehr länger hermetisch abgeschlossen sein müssen.

Entsprechend einer ersten bevorzugten Ausführungsform der Erfindung umfasst der erste Kühlkreislauf ein Rohrsystem, um eine Kühlflüssigkeit zu transportieren. Die Verwendung eines flüssigen Kühlmittels wie Wasser oder anderer geeigneter Kühlflüssigkeiten, insbesondere mit größerer Wärmekapazität als Luft, ist aus verschiedenen Gründen vorteilhaft. Zuerst ist die Gesamtwärmemenge, die übertragen oder transportiert werden kann, verglichen mit gasförmigen Kühlmitteln größer. Zweitens kann der Fluss und die Übertragung des Kühlmittels leichter kontrolliert und überwacht werden im Vergleich zu einem turbulenten oder laminaren Fluss eines gasförmigen Kühlmittels.

Darüber hinaus wird vorgeschlagen, dass das Kühlmittel im Kühlkreislauf, welcher Wasser oder jede andere Flüssigkeit mit vergleichsweise hoher Wärmekapazität enthalten kann, mit einem geringeren Druck als Atmosphärendruck befördert wird. Dadurch führt nicht jedes Leck im Rohrsystem sofort zu einem Verlust von Kühlflüssigkeit aus dem Rohrsystem. Stattdessen würde Umgebungsluft in das Rohrsystem eindringen und dadurch verhindern, dass empfindliche und teure Computerhardware durch das Kühlmittel beschädigt wird.

Die Stockwerke bzw. Ebenen des Hochregallagers sind gemäß einer weiteren bevorzugten Ausführungsform doppelbodenfrei. Hierdurch lässt sich Bauraum sparen und die Packungsdichte an Computerhardware erhöhen.

Darüber hinaus kann durch die Anwendung einer effizienten Isolation im Rohrsystem die Temperaturdifferenz zwischen Kühlmittelversorgung und dem Computerhardwarerack, welches gekühlt werden soll, auf ein Minimum reduziert werden, wohingegen gleichzeitig das erwärmte Kühlmittel aus dem Gebäude hinausgebracht oder zu einem Wärme- oder Kälte-Reservoir geführt werden kann, ohne das Gebäude selbst unbeabsichtigt aufzuwärmen.

Die Wärmetauschereinrichtungen, die entweder im Inneren oder in der direkten Nachbarschaft eines Computerhardwareracks installiert sind, sind geeignet, die vollständige im Rack erzeugte Wärme zum Kühlmittel zu übertragen. Deshalb bietet der Wärmetauscher jedes zu kühlenden Racks eine Wärmekoppelung zwischen dem zugeführten Kühlmittel und dem inneren Volumen des Racks.

Wegen des Rohrsystems, welches das Kühlmittel bereitstellt, kann die gesamte Struktur des Gebäudes in universeller und flexibler Weise geplant werden. Daher brauchen die verschiedenen Stockwerke des Gebäudes im Gegensatz zu früheren Lösungen nicht mehr länger für den Umgebungsluftstrom durchlässig zu sein. Auch ist es nicht mehr länger erforderlich, einen abgeschlossenen Kaltluftgang bereitzustellen, und zusätzlich ist es nicht mehr länger erforderlich, eine schwer zu handhabende globale Strömung von Kühlluft im Inneren des Rechenzentrumgebäudes zu kontrollieren.

Einer weiteren bevorzugten Ausführungsform gemäß umfasst die Struktur des Rechenzentrumgebäudes mindestens eine erste und zweite Ebene, welche durch eine Stahlträgerstruktur des Hochregallagers gestützt werden. Darüber hinaus sind drei oder sogar mehr Geschosse denkbar, die jeweils aufeinander angeordnet sind, wie sie ebenfalls im Rahmen des Erfindungsgedanken liegen. Insbesondere ist die Stahlträgerstruktur wie ein Hochregallager ausgebildet, wobei die Stahlträgerstruktur direkt als Träger für die Computerhardwareracks dient, weshalb zwischen den verschiedenen Computerracks angeordnete Bodensegmente oder Bodenplatten nicht mehr erforderlich sind.

Einer weiteren bevorzugten Ausführungsform gemäß werden die Racks direkt auf Doppel-T-Träger des Stahltragwerks aufgebracht. Weiterhin können Gitternetze oder vergleichbare Trägerstrukturen in den Abstandsflächen benachbart positionierter Racks angeordnet werden. Hier können die Gitternetze als eine Art Bodensegment dienen. Wegen ihres maschenartigen Designs können diese Gitternetze, abhängig von der Maschengröße, im Hinblick auf ihr Gewicht optimiert werden.

Einer weiteren bevorzugten Ausführungsform gemäß sind mindestens einige der Racks, die einen Wärmetauscher beinhalten, darauf ausgelegt, Wärme aus dem Kühlmittel, welches das Rohrsystem bereitstellt, auf einen luftbasierten Wärmetauscher zu übertragen. Hier ist es beabsichtigt, dass das gasförmige wärmetauschende Medium in thermischem Kontakt mit den Computerhardwarekomponenten im Inneren des Racks steht. Das erwärmte gasförmige wärmetauschende Medium ist des Weiteren in thermischem Kontakt mit dem Wärmetauscher und dient zur Übertragung der aufgesammelten Wärme auf die Kühlflüssigkeit im Rohrsystem.

Auf diese Weise kann die Strömung des gasförmigen Kühlmediums auf einen begrenzten Raum reduziert werden, insbesondere auf das Innere des jeweiligen Racks. So sind die Wärmetauschereinrichtungen in Kombination mit der Kühlflüssigkeit geeignet, sehr effektive Einrichtungen zu bilden, die eine Warmluftströmung außerhalb des Racks verhindern. Keine Warmluft kann vom Inneren des Racks nach draußen entweichen.

Des Weiteren können die Wärmetauschereinrichtungen die von der Computerhardware im Inneren des Racks erzeugte Warmluft direkt aufnehmen und können die Warmluft auf eine angestrebte Raumtemperatur einfach durch Transport der Wärme zum Kühlrohrsystem herunterkühlen. Dadurch kann sämtliche Strömung von heißer Luft im Inneren des Rechenzentrumgebäudes vermieden werden.

Auch kann die Entfernung, über welche heiße oder erwärmte Luft transportiert wird, auf ein Minimum reduziert werden. Es ist lediglich erforderlich, die erwärmte Luft im Inneren des Racks zu transportieren, insbesondere von der Computerhardware zum Wärmetauscher. Dadurch kann jeglicher schwer kontrollierbarer turbulenter Luftstrom vermieden werden. Stattdessen sorgt die Erfindung für eine gleichmäßige laminare Luftströmung, die grundsätzlich auf das Innere des Racks beschränkt ist.

Auch wenn der Wärmeaustausch zwischen einem flüssigen Kühlmittel und einem gasförmigen wärmetauschenden Medium eine einfache und bekannte Methode zum Erreichen einer effizienten und effektiven Kühlung ist, liegt es im Gedanken der vorliegenden Erfindung, dass das im Inneren des Racks verwendete wärmetauschende Medium ebenfalls flüssig statt gasförmig ist. So kann jedes Rack Wärmetauschereinrichtungen mit geeigneten Flanschen enthalten, um die Rackinterne Kühlarchitektur an den ersten Kühlkreis anzukoppeln, der darauf ausgelegt ist, verschiedene Racks untereinander zu verbinden und die erzeugte Wärme zu einem externen Reservoir zu transportieren.

Ein weiterer Vorteil der rackbasierten Wärmetauschereinrichtung ist, dass die Racks ihrerseits nicht geschlossen sind und dass die Luftströmung in das Rack hinein und aus ihm heraus nicht mehr kontrolliert werden muss. Als ein weiterer Vorteil sind im Inneren des Rechenzentrumgebäudes keine zusätzlichen Klimaanlagen erforderlich, da die Kühlfunktion vollständig durch die Wärmetauscher im Inneren der Racks übernommen werden kann.

Weil insbesondere die Wärmetauscher eine ziemlich große Oberfläche besitzen, kann eine relativ langsame und laminare Luftströmung im Inneren des jeweiligen Racks erzielt werden, und so kann die Geschwindigkeit optionaler Lüfter reduziert und dadurch der damit verbundene Stromverbrauch der Kühlung minimiert werden. Gemäß einer weiteren bevorzugten Ausführungsform umfassen wenigstens einige der Racks mindestens einen Lüfter. Vorzugsweise haben alle Racks, die mit Wärmetauschereinrichtungen ausgestattet sind, mindestens einen Lüfter, der entweder direkt mit dem Wärmetauscher verbunden oder in enger Nachbarschaft zum Wärmetauscher angeordnet ist, um im Inneren des jeweiligen Racks genügend Kaltluftzirkulation bereit zu stellen.

Gemäß einer weiteren Ausführungsform der Erfindung werden alle Wärmetauschereinrichtungen, die mindestens einen Lüfter besitzen, paarweise und einander benachbart angeordnet. Dadurch liefert die Erfindung Redundanz für den Fall, dass ein Wärmetauscher eines Paares Fehlfunktionen haben sollte. In diesem Fall kann die Wärmetauschereinrichtung eines benachbart aufgestellten Racks die Funktion derjenigen Wärmetauschereinrichtung übernehmen, welche ausgefallen ist. Weiterhin kann die Geschwindigkeit des Lüfters der intakten Wärmetauschereinrichtung individuell erhöht werden, um die Leistung der ausgefallenen benachbarten Wärmetauscherseinrichtung oder des Lüfters auszugleichen.

Daher ist es von Vorteil, dass mindestens einige der Racks Steuereinrichtungen zur individuellen Regulierung der Wärmetauschereinrichtungen besitzen. Auf diese Weise kann das gesamte System lokal angepasst auf Systemfehler reagieren und automatisch geeignete Vorkehrungen treffen, um die Fehlfunktion auszugleichen.

Eine andere Ausführungsform betreffend beinhalten die Steuereinrichtungen zusätzlich Leckagedetektoren für das Rohrsystem und/oder Rauchdetektoren, wobei diese Detektoren an ein Notfallsystem angeschlossen sind, welches dazu ausgebildet ist, selektiv die Hardware und/oder die betreffenden Zweige des Kühlsystems abzuschalten.

Das Notfallsystem kann bevorzugt für jedes beliebige der genannten Racks individuell ausgelegt und angebracht werden, separiert von den Notfallsystemen benachbarter oder gegenüber stehender Racks. Rauch- und Leckagedetektoren können separat und unabhängig voneinander installiert werden, um brennende oder schmorende Computerhardware individuell abzuschalten und den übrigen Betrieb des Rechenzentrums aufrecht erhalten zu können. Alternativ sind auch eine verbundene Anordnung einzelner Detektoren und die Nutzung eines multifunktionalen Detektors denkbar.

Gemäß einer weiteren Ausführungsform umfassen die Racks zusätzlich Leistungssteuerungselemente, die geeignet sind, den Einschaltstrom unter einer vorgegebenen Grenze zu halten. Diese Ausführungsform dient dazu, zu verhindern, dass das gesamte Rechenzentrum eine dynamische Strombelastung erzeugt, die von einem externen Netzgerät nicht geliefert werden kann. Daher sind die Leistungssteuerungselemente dafür geeignet, zu steuern, dass jedes Rack oder ein Paar von Racks die Leistung von einem elektrischen Strom- oder Spannungsnetzgerät nach einem vorgegebenen Zeitschema zieht.

Zum Beispiel kann ein erstes Rack einen Einschaltzyklus nach Ablauf einer bestimmten Verzögerungszeit relativ zu irgend einem anderen Rack des Rechenzentrums beginnen. Dadurch kann die Spitzenleistungsaufnahme des gesamten Rechenzentrumgebäudes unterhalb einer vorgegeben Grenze gehalten werden, und auf diese Weise sicherstellen, dass die externe Stromversorgung nicht zusammenbricht. Beide Leistungssteuerungseinrichtungen können als spezifischer Algorithmus implementiert werden, der jedem der Racks des Rechenzentrumgebäudes individuelle, verschiedene Zeitverzögerungen zuordnet.

Alternativ ist es auch denkbar, dass der Einschaltzyklus der verschiedenen Racks durch Einrichtungen einer zentralen Architektur gesteuert wird. Jedoch ist auch ein untereinander verbundenes Notfallsystem in den Anwendungsmöglichkeiten dieser Erfindung, wobei eine Vielzahl von Leckage- und/oder Rauchdetektoren elektrisch mit einem zentralen Notfallsystem verbunden sind, welches automatisch geeignete Maßnahmen ergreift, um einem Systemfehler entgegenzuwirken.

In einer weiteren bevorzugten Ausführungsform beinhaltet das Rechenzentrum noch einen zweiten Kühlkreislauf, der im Prinzip die gleiche Struktur wie der erste Kühlkreislauf aufweist. Jedoch sind der erste und der zweite Kühlkreislauf abwechselnd in jedem Stockwerk des Rechenzentrumgebäudes angeordnet. Wenn im Einzelnen die Racks eines jeden Stockwerks spalten- oder zeilenweise aufgestellt sind, wird jede zweite Spalte oder Reihe von Racks, zum Beispiel die geradzahlig nummerierten Spalten oder Reihen, typischerweise mit dem ersten Kühlkreislauf verbunden, wohingegen die ungeradzahlig nummerierten Spalten oder Reihen mit dem zweiten Kühlkreislauf verbunden werden. Auf diesem Wege kann sogar im Falle einer Fehlfunktion im ersten oder zweiten Kühlkreislauf der verbleibende intakte Kühlkreislauf die gesamte Kühlung aller Racks des betreffenden Stockwerks übernehmen.

Die kompakte Architektur der bevorzugten Ausführungsform erlaubt den Betrieb des Rechenzentrums bei einer relativ hohen Umgebungstemperatur, womit auch die Temperatur des flüssigen Kühlmittels ansteigt. Höhere Temperaturen einer Kühlflüssigkeit erlauben ein effizienteres Kühlen. Im Falle, dass die Kühlmitteltemperatur sich 30° C annähert, kann die Wärme, die von der Computerhardware aufgenommen wird, benutzt werden, andere Teile eines Gebäudes insbesondere im Winter zu heizen, ohne dass die Notwendigkeit zur Nutzung von Wärmepumpen besteht.

Einem andern Gesichtspunkt gemäß sind der erste und/oder zweite Kühlkreislauf direkt an die Heizanlagen eines separaten Gebäudes oder Gebäudeteils angebunden, welche sich in enger Nachbarschaft zur Struktur des Rechenzentrumgebäudes befinden. Durch Ausnutzen einer erwärmten Kühlmitteltemperatur von um die 30° C können umliegende Gebäude oder Gebäudeteile direkt geheizt werden ohne die Notwendigkeit, zusätzliche Einrichtungen wie z.B. Wärmepumpen verwenden zu müssen. Insbesondere kann der Kühlkreislauf direkt mit einer Bauteilaktivierung oder vergleichbaren Heizeinrichtungen der Gebäude oder Gebäudeteile verbunden werden, um diese bevorzugt auf Temperaturen von 17 °C und darüber zu erwärmen.

Des Weiteren sind der erste und/oder der zweite Kühlkreislauf geeignet, mit einem externen Wärmereservoir verbunden zu werden. Das Wärmereservoir kann als Energiespeicher dienen, zum Beispiel um im Winter die aus der Computerhardware während der Nacht angesammelte Wärme zu speichern und mehr Wärmeenergie für Gebäude am Tag bereitzustellen. Im Sommer kann das Wärmereservoir genutzt werden, um Wärme tagsüber zu speichern, um in der Nacht aufgrund der kälteren Umgebungstemperatur mit größerer Effizienz abzukühlen.

Einer weiteren Ausführungsform entsprechend können die Doppel-T-Träger des Tragwerks, z.B. des Stahltragwerks, überdies als Führung und Tragwerk für einen Aufzug dienen, der geeignet ist, gesamte Racks eines Stockwerks über die Stockwerkebene zu transportieren und zu heben. Dadurch kann die Konfiguration und die Neukonfiguration des gesamten Gebäudes des Rechenzentrums bewerkstelligt werden ohne die Notwendigkeit, eine Stockwerkstruktur zum Transport der Computerhardwareracks bereitzustellen.

Einem anderen und unabhängigen Gesichtspunkt entsprechend betrifft die Erfindung die Verwendung eines Racks für Computerhardware zur Anordnung in einem oben beschriebenen Rechenzentrum. Darüber hinaus kann das Computerhardwarerack Kontrolleinrichtungen beinhalten, die darauf ausgelegt sind, individuell und/oder autonom die Wärmetauschereinrichtung des Racks zu steuern.

Die Wärmetauschereinrichtung ist derart dimensioniert, dass die gesamte von der Computerhardware erzeugte Wärmemenge abtransportierbar ist, sodass keine Wärmeabgabe an die Umgebung des Racks stattfindet.

Gemäß einem anderen Gesichtspunkt betrifft die Erfindung ein Verfahren zur Kühlung der Rechenzentrumgebäudestruktur, die eine Vielzahl von Computerhardwareracks beinhaltet, von denen jedes Speicherplatz für Computerhardware umfasst. Das Verfahren bietet einen Ansatz, die gesamte von der Computerhardware erzeugte Wärme stufenweise durch Befördern des Kühlmittels zu den Racks durch Einrichtungen eines ersten Kühlkreislaufs und durch Übertragen der Wärme mittels Wärmetauschereinrichtungen abzuleiten und schließlich durch Befördern des erwärmten Kühlmittels weg von den Racks an ein Kühlsystem durch Verwendung einer Wärmetauschereinrichtung, welche an jedem zu kühlenden Rack aufgebaut ist. Dadurch kann eine individuelle und separate rackbezogene Kühlung des Rechenzentrumgebäudes bereitgestellt werden. Auch kann die Kühlung den Kühlungsanforderungen jeden Racks individuell angepasst werden.

Darüber hinaus wird das Verfahren zur Kühlung des Rechenzentrumgebäudes dadurch gekennzeichnet, dass die Wärmetauschereinrichtungen separat und/oder autonom gesteuert werden. Diese separate und autonome Steuerung der rackspezifischen Wärmetauscher- und Kühleinrichtungen erlauben es, eine beliebig viele Stockwerke umfassende Gebäudestruktur mit einer erhöhten Packungs- und Speicherdichte aufzubauen, welche eine genügend große Wärmeableitung bietet, die sogar eine volumenbezogene Wärmeableitungsrate von 10 kW/m³ überschreiten kann.

Dadurch dass ein Kühlkreislauf verwendet wird, der darauf ausgelegt ist, flüssige Kühlmittel zu befördern, kann die Vielseitigkeit der Gebäudearchitektur vergrößert werden, da das Kühlmittel an jede Stelle im Inneren der Gebäudestruktur befördert werden kann, wo durch die Einrichtungen der Computerhardware Wärme erzeugt wird.

### Ausführungsbeispiel

Im Folgenden werden bevorzugte Ausführungsformen der Erfindung im Detail beschrieben, wobei auf die Figuren Bezug genommen wird, in denen:
- Figur 1: schematisch ein herkömmliches Rechenzentrumgebäude darstellt und
- Figur 2: schematisch eine zwei Stockwerke umfassende Rechenzentrum Gebäudestruktur gemäß der vorliegenden Erfindung darstellt.

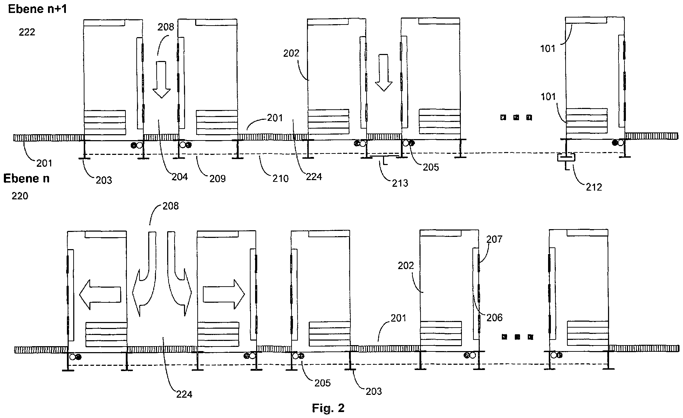

In Figur 2 werden zwei Stockwerke einer Rechenzentrumgebäudestruktur dargestellt. Die Computerhardware 101 tragende Struktur als Hochregallager ausgebildet ist, das regelmäßig angeordnete T-Trägern 203 aufweist, welche vorzugsweise Stahl aufweisen. Die horizontale Entfernung zwischen benachbarten Stahl-T-Trägern ist an Größe und Geometrie der Racks 202 angepasst, die Speicherplatz für die Computerhardware 101 bereitstellen. Das Hochregallager weist mehrere Ebenen 220, 222 auf, in denen Computerhardware 101 in Racks 202 angeordnet ist.

Zum Beispiel korrespondiert die Entfernung eines Paares von Stahl-T-Trägern mit der horizontalen Ausdehnung der Racks 202. Dadurch können die Racks 202 direkt auf die Stahl-T-Träger montiert werden. Jedoch kann der Abstand zwischen Paaren von Stahl-T-Trägern unterschiedlich sein. In der Darstellung von Figur 2 kann die Abstandsfläche 204 zwischen benachbart angeordneten Racks 202 bis zu einer Abstandsfläche 224 abweichen. Jedoch, wenn auch nicht notwendig erforderlich, werden die Abstandsflächen 204, 224 typischerweise von den Gitternetzelementen bedeckt, so dass Kühlluft in vertikaler Richtung durchströmen kann.

Wie in der Ausführungsform von Figur 2 dargestellt, umfasst jedes der Racks 202 eine separate Wärmetauschereinheit 206, die mit einem Wärmetauscher und optional mit einem oder mehreren Lüfter 207 ausgestattet sein kann, um die Strömung der Kühlluft im Inneren des Racks 202 zu fördern. Alle Wärmetauschereinheiten 206 sind mit einem Rohrsystem 205 verbunden, welches Kühlflüssigkeit, z.B. Wasser, zu jedem der Racks 202 befördert. Zusätzlich sind die Wärmetauschereinheiten 206 mit geeigneten Lüftern 207 von paarweise benachbart aufgestellten Racks 202 in einer Reihe dazu ausgebildet, Redundanz für den Fall bereit zu stellen, dass eine der Wärmetauschereinheiten 206 oder deren Lüfter 207 eine Fehlfunktion bekommen.

In einem solchen Fall können die Wärmetauschereinheit 206 und der Lüfter 207 eines benachbarten oder gegenüber stehenden Racks 202 die Kühlfunktion der ausgefallenen Wärmetauschereinheit übernehmen.

Das mittels eines Rohrsystems 205 bereitgestellte Kühlmittel weist den Vorteil auf, dass die verschiedenen Racks 202 nicht mehr länger als geschlossene Racks ausgebildet sein müssen. Darüber hinaus kann die Wärmeableitung außerhalb der verschiedenen Racks 202 effektiv auf ein Minimum reduziert werden. So ist es nicht länger erforderlich, einen globalen Luftstrom im Inneren der Gebäudestruktur zu steuern. Dadurch kann die Entstehung von heißen Bereichen auf Grund von einiger turbulent strömender Luft außerhalb der Racks 202 effektiv unterbunden werden.

Zusätzlich muss der Luftstrom in der Struktur des Rechenzentrumgebäudes nicht länger aktiv gesteuert werden, weil die Umgebungstemperatur um die Racks 202 herum auf einem relativ kühlen Level gehalten werden kann im Vergleich zur Temperatur im Inneren der Racks 202.

Um Fehlertoleranz in der Kühlungsinfrastruktur zu verwirklichen, können die Racks 202 in einer gerade/ungerade-Art betrieben werden, wobei jedes zweite Rack mit dem-selben Rohrsystem verbunden ist, nämlich entweder mit dem ersten oder dem zweiten Kühlkreislauf. Auf diese Weise können zwei redundante Kühlkreisläufe betrieben werden, die überschüssige Kühlkapazität bereit stellen. Die Gebläsekapazität der Lüfter 207 der Wärmetauschereinheit 206 ist bevorzugt überdimensioniert, wodurch der Ausfall eines Lüfters dadurch ausgeglichen werden kann, dass die anderen intakten Lüfter des selben oder des benachbarten Racks 202 mit einer passenden höheren Geschwindigkeit betrieben werden.

Im Falle einer Fehlfunktion, zum Beispiel hervorgerufen durch ein Leck im Rohrsystem 205, kann ein bestimmtes Rack 202 selektiv vom Rohrsystem 205 abgekoppelt werden. Solch ein abgekoppeltes Rack 202 könnte dadurch gekühlt werden, dass gegenüberliegende benachbarte Racks als eine Art Ersatzkühleinrichtung verwendet werden, die mit höherer Lüftergeschwindigkeit betrieben werden können. Sogar wenn ein gesamtes Kühlsystem ausfällt, kann die zweite Gruppe von Racks 202, die an den zweiten Kühlkreislauf angeschlossen ist, in gleicher Weise die Kühlung der nächsten Nachbarn dadurch übernehmen, dass ihre Lüfter mit passender höherer oder sogar maximaler Geschwindigkeit betrieben werden. Auf diese Weise können die intakten Wärmetauschereinrichtungen und ihre Kühlungslüfter die heiße Luft ihrer jeweiligen Nachbarn aufnehmen. Wenn jedoch zum Beispiel die Kühlkapazität nicht mehr länger ausreicht, könnte auch die Temperatur des Kühlmittels verringert werden, um so sofort eine höhere Kühleffizienz zu liefern.

Weil es keine Notwendigkeit gibt, irgendwelche Luftströmungen durch die Struktur des Rechenzentrumgebäudes zu leiten, können die Computerhardwareracks 202 in jeder beliebigen Anordnung montiert und aufgestellt werden, insbesondere auch durch Nutzung der dritten Dimension. In der Ausführungsform, wie sie in Figur 2 dargestellt ist, sind die Racks 202 Seite an Seite montiert und sie sind typischerweise in Reihen aufgestellt, wobei Vorderseite zu Vorderseite und Rückseite zu Rückseite einander gegenüber stehen, um den verfügbaren Platz optimal auszunutzen.

Andere Ausführungen sind denkbar, wobei die Racks Vorderseite zu Rückseite angeordnet sind, so dass die nächste Reihe die Luft direkt von den Wärmetauschern der vorherigen Reihe aufnimmt. Jedoch benötigt dieses Szenarium ein wenig mehr Platz, weil die Abstände zwischen den Reihen der Racks 202 nicht kleiner ausfallen können als die Länge eines Rack-Einschubes, z.B. eines 19 Zoll-Einschubes.

Die Kühlmittelversorgung für jedes einzelne Rack 202 ist insbesondere vorteilhaft, weil es eine Mehrstockwerk-Stahlstruktur für die Computerhardwareracks erlaubt. Im Gegensatz dazu wird bei konventionellen, auf Luftströmung beruhenden Kühlsystemen eine obere Grenze der Kühlkapazität schnell erreicht, sobald die Struktur des Rechenzentrumgebäudes mehr als 2 Stockwerke hat. Darüber hinaus wird die nur auf Luftströmung beruhende Kühlung mit wachsender Gebäudegröße mehr und mehr ineffizient, insbesondere bei zunehmender Höhe des Gebäudes.

Wie des Weiteren in Figur 2 dargestellt, kann die über den Racks erforderliche lichte Höhe in einer ziemlich niedrigen Grenze gehalten werden, zum Beispiel bei etwa 50 cm, wodurch eine Höhe von 2,50 m erzielt wird, wenn Racks von 2 m Höhe eingebaut werden. Die Stahlträgerstruktur 203 trägt nicht nur die Racks 202, sondern auch kostengünstige Gitterbodenelemente 201, die geeignet sind, Wartungsarbeiten in solch einer Hochregalmehrgeschossarchitektur zu ermöglichen. Im Ergebnis kann das Hochregallager des Rechenzentrums ein Stahlgitter enthalten, welches aus sehr kostengünstigen Standardbauteilen aufgebaut ist. Unterschiedliche Reihenabstände und Stockwerkhöhen können zusammengestellt und/oder nach Bedarf angepasst werden, einfach durch Verschieben der in Standardgröße verwendeten T-Träger 203. Die offene Bodenstruktur kann zusätzlich einen Luftstrom 208 zwischen den verschiedenen Stockwerken bieten.

Die Stahlträger bieten eine Standard-Befestigung für das Kühlwasserrohrsystem 205 und für geeignete Kabelkanäle für die Verkabelung 209, 210. Unterhalb jeder Rackreihe ist durch direkte Anbringung an die T-Träger ein longitudinaler Standard-Kabelkanal montiert, wie in Zeichnung 2 dargestellt. Transversale Kabelkanäle 210 sind eingebracht, wodurch ein Kabelkanalgitter mit anpassbarem Abstand bereit gestellt wird. Sie sind ebenso wie die Kanäle 201 an den T-Trägern angebracht. Die Verbindung zu den longitudinalen Kabelkanälen 209 wird durch passende Löcher in den T-Wabenträgern bereit gestellt.

Vertikale Verkabelung kann leicht ermöglicht werden zwischen den oberen Enden der Racks und/oder deren Boden oder durch Einbringung vertikaler Kabelkanäle an freien Plätzen. Diese Architektur macht die Decke bzw. Ebene von Stockwerk n des Hochregallagers zum Doppelboden von Stockwerk n+1 des Hochregallagers. Die Einbringung der Computerhardware in mehrere Stockwerke führt zur kürzesten mittleren Entfernung der Verkabelung für jedes gegebene System, weil dieser Parameter nur mit der dritten Wurzel des Systemvolumens wächst. Die weitgehend offene Architektur erlaubt kürzestmögliche Kabelwege zwischen zwei beliebigen Punkten und führt daher zur kürzestmöglichen Latenz zwischen den Knoten.

Der Bodenteil der T-Träger, welche die Racks tragen, kann verwendet werden, um einen beweglichen Haken mit angeschlossenem Hebezeug 212, 213 bereitzustellen, wodurch ein kostengünstiger beweglicher Kran oder Aufzug entsteht, der die Installation von schwerem Gerät unterstützt.

Der Luftstrom in den Racks kann optimiert werden, um eine geringe Temperaturdifferenz zwischen den heißen Stellen im Inneren der Computerhardware und der Umgebungstemperatur zu erzeugen. Unter der Annahme einer nach dem Stand der Technik gegebene Temperaturdifferenz von weniger als 20° C zwischen der Umgebungsluft und den heißen Stellen im Inneren des Racks 202, ist eine Ablufttemperatur von 40° C denkbar, wodurch die Wärmetauscher bei 30° C mit einer Temperaturdifferenz zur Kühlluft von 10° C betrieben werden können.

Eine Erhöhung der Umgebungstemperatur im Rechenzentrum erhöht daher die Kühlwassertemperatur, wodurch direkt die Kühleffizienz des erwärmten Kühlwassers gesteigert wird. Der kostengünstige Platz im Rechenzentrum erlaubt die Benutzung größerer Gehäuse, wie 3U 19"-Systeme oder Bladesysteme, die großflächige Lüfter verwenden und größere Mengen von Luft mit kleinerer Geschwindigkeit bewegen. Die Lüfter 207 können diese Luftströmung unterstützen und mithelfen, die Lüftergeschwindigkeit im Inneren der Computer weiter zu vermindern.

Die Lüftergeschwindigkeit im Wärmetauscher ist für die Anforderungen der spezifischen Geräte im Rack optimiert. Einerseits wird die aufgenommene Energie durch Ermittlung der Primärströme in den Computer hinein gemessen, wodurch die abzuführende Wärme definiert ist. Die gemessene Temperatur der Umgebungsluft und die Temperatur des Wärmetauschers bestimmen die zur Kühlung erforderliche Luftströmung und damit die Lüftergeschwindigkeit.

Andererseits wird die Umgebungstemperatur oben an der Rückseite des Racks gemessen. Im Falle eines ungenügenden Luftstroms durch den Wärmetauscher wird diese Temperatur wegen der heißen Luft, die aus dem Rack austritt, ansteigen. Somit wird das Betriebsverhalten des Kühlystems unabhängig für jedes einzelne Rack verifiziert.

Im Betrieb strömt alle Luft, welche aus den Computern im Rack austritt, durch den zugeordneten Wärmetauscher. Dadurch ist es möglich, Überhitzungen im Rack durch Rauchdetektoren im Luftstrom festzustellen. Im Falle eines solchen Fehlers kann die primäre Stromversorgung der Computer spezifisch im Rack abgeschaltet werden, nachdem ein Notfall-Shutdown der Maschinen im Rack versucht wurde. Normale Computer stellen keine signifikante Brandlast dar, und daher wird das Abschalten der primären Stromversorgung ein kritisches Anwachsen oder eine Eskalation des Problems stoppen. Dadurch dass man die primäre Stromversorgung eines Racks steuern kann, kann auch ein Einschalten geplant werden, um die Einschaltströme zu begrenzen. In der bevorzugten Ausführungsform der Erfindung handeln die jeweiligen Racks einen Ablaufplan zum Einschalten der Computer aus.

Eine Betriebstemperatur von 30° C erlaubt die direkte Nutzung des Kühlwassers zur Heizung nahegelegener Bürogebäude, wenn diese Boden- und Wandheizung besitzen. Im Sommer kann die Wärme des Rechenzentrums zur Kühlung von Gebäuden genutzt werden, indem Konvektionskühler verwendet werden.

Die Energie des Kühlwassers kann nachts in einem latenten Wärmereservoir gespeichert werden, wo die Bürogebäude viel weniger Wärme benötigen. Tagsüber ist eine entsprechend größere Wärmemenge zur Heizung verfügbar, wodurch die konstant erzeugte Wärme des Rechenzentrums an den Nutzungszyklus des Bürogebäudes angepasst wird.

Eine andere Anwendung des latenten Wärmespeichers wird im Sommer bei Spitzentemperaturen genutzt. Während dieser Zeit könnte nicht alle Wärme nutzbar sein und müsste weg befördert werden. Da die Kühleffizienz mit abnehmender Außentemperatur sinkt, wird das Wärmereservoir hier tagsüber genutzt, die Wärme zu speichern, und die Wärmemenge während der Nacht abzuleiten, wenn die Außentemperatur signifikant niedriger ist.

**Referenzliste der Referenz-Nummern**

| | | | |
|---|---|---|---|
| 101 | Computerhardware | | |
| 102 | Rack | | |
| 103 | Kaltluftgang | | |
| 104 | Platte des offenen Bodens | | |
| 105 | Platte des geschlossenen Bodens | | |
| 106 | Erdgeschoss | | |
| 107 | Doppelboden T-Träger | | |
| 108 | Kaltluftströmung | | |
| 110 | Luftströmung | | |
| 111 | Luftströmung | | |
| 201 | Gitterboden | | |
| 203 | stählerner T-Träger | | |
| 204 | Abstandsfläche | | |
| 205 | Rohrsystem | | |
| 206 | Wärmetauschereinheit | | |
| 207 | Lüfter | | |
| 208 | Luftströmung | | |
| 209 | longitudinaler KabelKabel | | |
| 210 | seitlicher Kabelkanal | | |
| 212 | Kran | | |
| 213 | Kran | | |
| 220 | Stockwerk n | 222 | Stockwerk n+1 |
| 224 | Abstandsfläche | | |

## Patentansprüche

1. Rechenzentrum mit mindestens einem ersten Stockwerk bzw. Ebene (220) und einem zweiten Stockwerk bzw. Ebene (222), wobei die Stockwerke (220, 222) als Hochregallager ausgebildet sind und eine Mehrzahl von Racks (202) beinhalten, wobei jedes einzelne Speicherplatz für Computerhardware (101) beinhaltet, wobei das Rechenzentrum weiterhin einen ersten Kühlkreislauf aufweist, um die von der Computerhardware (101) erzeugte Wärme abzuleiten und wobei der erste Kühlkreislauf dazu ausgebildet ist, alle Racks (202) mit einem Kühlmittel zu versorgen, wobei der erste Kühlkreislauf weiterhin dazu ausgebildet ist, das erwärmte Kühlmittel von diesen Racks (202) wegzuführen, **dadurch gekennzeichnet, dass** diese genannten Racks (202) Wärmetauschereinrichtungen (206, 207) aufweisen, die dazu ausgebildet sind, die erzeugte Wärme auf das Kühlmittel zu übertragen, wobei die Wärmetauschereinrichtungen (206, 207) derart dimensioniert sind, dass über diese die komplette von der Computerhardware (101) erzeugte Wärmemenge abführbar ist, sodass während des Betriebes aus der Mehrzahl von Racks (202) keine Warmluft an das Rechenzentrum abgegeben wird und jedes Rack eine individuelle Ankopplung an den Kühlkreislauf aufweist und die Racks eine offene Rack-Architektur aufweisen.

2. Rechenzentrum gemäß Anspruch 1, wobei das Kühlmittel im Kühlkreislauf mit einem geringeren Druck als Atmosphärendruck transportiert wird.

3. Rechenzentrum nach Anspruch 2, wobei der erste Kühlkreislauf als Unterdrucksystem ausgebildet ist.

4. Rechenzentrum nach einem der vorangegangenen Ansprüche, wobei die Stockwerke bzw. Ebenen (220, 222) doppelbodenfrei sind.

5. Rechenzentrum gemäß einem oder mehreren der vorangegangenen Ansprüche, aufweisend mindestens ein erstes und ein zweites Stockwerk (220, 222), die auf eine Trägerstruktur gestützt sind.

6. Rechenzentrum nach Anspruch 5, in welchem Racks (202) direkt auf Doppel-T-Trägern der Trägerstruktur angeordnet sind, bevorzugt auf einer Stahlträgerstruktur, und wobei Gitternetze (201) in den Abstandsflächen benachbart lokalisierter Racks (202) angeordnet sind.

7. Rechenzentrum gemäß einem oder mehreren der vorangegangenen Ansprüche, in welchem sich Racks (202) befinden, die Wärmetauschereinheiten (206) aufweisen, die darauf ausgelegt sind, Wärme zwischen einem Kühlmittel und einem gasförmigen Wärmetauschmedium zu übertragen, vorzugsweise sind die Wärmetauscheinheiten (206) und/oder Lüfter (207) von paarweise benachbart aufgestellten Racks (202) mit ihren Vorderseiten einander gegenüberstehen.

8. Rechenzentrum gemäß einem oder mehreren der vorangegangen Ansprüche, worin wenigstens einige der Racks (202) Kontrolleinrichtungen zur individuellen Steuerung der Wärmeaustauscheinrichtungen (206, 207) aufweisen, vorzugsweise haben die Kontrolleinrichtungen des Weiteren (i) einen Leckdetektor für das Rohrsystem (205), wobei der genannte Detektor an ein Notfallsystem angeschlossen ist, das dazu ausgebildet ist, selektiv die Hardware (101), insbesondere rackspezifisch, und/oder den Kühlkreislauf auszuschalten und/oder (ii) einen Rauchdetektor, wobei der genannte Detektor an ein Notfallsystem angeschlossen ist, um selektiv die Hardware (101), insbesondere rackspezifisch, und/oder den Kühlkreislauf auszuschalten.

9. Rechenzentrum gemäß einem oder mehreren der vorangegangen Ansprüche, worin die Racks (202) des Weiteren eine Stromeinschalteinrichtung aufweisen, die geeignet ist, den elektrischen Einschaltstrom unter einer vorgegebenen Grenze zu halten.

10. Rechenzentrum gemäß einem oder mehreren der vorangegangen Ansprüche, bei dem weiterhin ein zweiter Kühlkreislauf vorgesehen ist, der prinzipiell dieselbe Struktur wie der erste Kühlkreislauf aufweist, wobei die Abschnitte der Rohrsysteme des ersten und zweiten Kühlkreislaufs abwechselnd in jeder Reihe von Racks (202) angeordnet sind.

11. Rechenzentrum gemäß irgendeinem der vorangegangenen Ansprüche 6 bis 10, worin die Doppel-T-Träger (203) als Führungs- und Stützstruktur für ein Hebezeug (213, 212) dienen.

12. Rechenzentrum gemäß einem oder mehreren der vorangegangen Ansprüche, worin ein erster und/oder zweiter Kühlkreislauf an einen externen Wärmespeicher angekoppelt ist.

13. Rechenzentrum gemäß einem oder mehreren der vorangegangen Ansprüche, wobei der erste und/oder der zweite Kühlkreislauf direkt an eine Heizeinrichtung eines separaten Gebäudes oder einer Gebäudeeinheit gekoppelt sind, um diese zu erwärmen, bevorzugt auf 17 °C und mehr.

14. Verwendung eines Racks für Computerhardware (101) in einem Rechenzentrum gemäß einem oder mehreren der vorangegangenen Ansprüche 1 bis 13, wobei das Rack Speicherplatz für Computerhardware (101) und Wärmetauschereinrichtungen (206, 207) aufweist, die dazu ausgebildet sind, die komplette von der Computerhardware (101) erzeugte Wärme auf das Kühlmittel zu übertragen und abzuleiten, sodass während des Betriebes des Racks (202) keine Warmluft an das Rechenzentrum abgegeben wird und jedes Rack eine individuelle Ankopplung an den Kühlkreislauf aufweist und die Racks eine offene Rack-Architektur aufweisen.

15. Verfahren zur Kühlung der Struktur eines Rechenzentrums, welches eine Vielzahl von Racks (202) in einem Hochregallager umfasst, von denen jedes Speicherplatz für Computerhardware (101) beinhaltet, die Wärme erzeugt; mit folgenden Schritten;
- befördern eines Kühlmittels zu den Racks mit Hilfe eines ersten Kühlkreislaufs,
- übertragen der kompletten, von der Computerhardware (101) im Rack erzeugten Wärme auf das Kühlmittel mittels Wärmetauschereinrichtungen (206, 207) und
- befördern des erwärmten Kühlmittels weg von den Racks (202), wobei
- die Wärmetauscheinrichtungen individuell an den Kühlkreislauf angekoppelt sind und separat und/oder autonom geregelt werden können,
- die Racks eine offene Rack-Architektur aufweisen und
- die Racks keine Warmluft an das Rechenzentrum abgeben.

## Claims

1. A data centre comprising at least a first storey or respectively level (220) and a second storey or respectively level (222), wherein the storeys (220, 222) are configured as high bay racking and comprise a multiplicity of racks (202), each of which comprising storage space for computer hardware (101), wherein the data centre further comprises a first cooling circuit for dissipating the heat generated by the computer hardware (101), and wherein the first cooling circuit is configured to supply all the racks (202) with a coolant, wherein the first cooling circuit is further configured to convey the heated coolant away from the these racks (202), **characterized in that** said racks (202) comprise heat exchanging means (206, 207) which are configured to transfer the generated heat to the coolant,
wherein the heat exchanging means (206, 207) are dimensioned such that via these the entire amount of heat generated by the computer hardware (101) is able to be discharged, so that during the operation no warm air is emitted from the plurality of racks (202) to the data centre, and each rack has an individual coupling to the cooling circuit, and the racks have an open rack architecture.

2. The data centre according to Claim 1, wherein the coolant is transported within the cooling circuit with a pressure lower than atmospheric pressure.

3. The data centre according to Claim 2, wherein the first cooling circuit is configured as a vacuum system.

4. The data centre according to one of the preceding claims, wherein the storeys or respectively levels (220, 222) do not have false floors.

5. The data centre according to one or more of the preceding claims, having at least a first and a second storey (220, 222), which are supported on a supporting structure.

6. The data centre according to Claim 5, in which the racks (202) are directly arranged on double T-beams of the supporting structure, preferably on a steel beam structure, and wherein grids (201) are arranged in the spacings of adjacently localized racks (202).

7. The data centre according to one or more of the preceding claims, in which racks (202) are situated, which comprise heat exchanger units (206) which are designed to transfer heat between a coolant and a gaseous heat exchange medium, preferably the heat exchanger units (206) and/or fans (207) of racks (202) installed in pairs in an adjacent manner are facing each other with their front sides.

8. The data centre according to one or more of the preceding claims, wherein at least some of the racks (202) have control systems to individually control the heat exchanging means (206, 207), preferably the control means have furthermore (i) a leakage detector for the piping system (205), wherein said detector is connected to an emergency system which is configured to selectively switch off the hardware (101), in particular in a rack-specific manner, and/or to switch off the cooling circuit, and/or (ii) a smoke detector, wherein said detector is connected to an emergency system in order to selectively switch off the hardware (101), in particuar in a rack-specific manner, and/or to switch off the cooling circuit.

9. The data cetnre according to one or more of the preceding claims, wherein the racks (202) further comprise a system for switching on electricity which is suitable to maintain the electrical starting current below a predefined limit.

10. The data centre according to one or more of the preceding claims, wherein further a second cooling circuit is provided having, basically, the same structure as the first cooling circuit, wherein the sections of the piping systems of the first and second cooling circuit are alternately arranged in each row of racks (202).

11. The data centre according to any one of the preceding Claims 6 to 10, wherein the double T-beams (203) serve as guiding and supporting structure for a lifting device (213, 212).

12. The data centre according to one or more of the preceding claims, wherein a first and/or second cooling circuit is coupled with an external heat reservoir.

13. The data centre according to one or more of the preceding claims, wherein the first and/or the second cooling circuit are coupled directly with a heating system of a separate building or a building unit in order to heat them, preferably to 17°C and higher.

14. A use of a rack for computer hardware (101) in a data centre according to one or more of the preceding Claims 1 to 13, wherein the rack has storage space for computer hardware (101) and heat exchanger means (206, 207) which are configured to transfer and discharge the entire heat generated by the computer hardware (101) to the coolant, so that during the operation of the rack (202) no hot air is emitted to the data centre and each rack has an individual coupling to the cooling circuit and the racks have an open rack architecture.

15. A method for cooling the structure of a data centre, comprising a multiplicity of racks (202) in a high bay racking, each of which comprises storage space for computer hardware (101) which generates heat; with the following steps:
- conveying a coolant to the racks by means of a first cooling circuit,
- transferring the entire heat generated in the rack by the computer hardware (101) to the coolant by means of heat exchanging means (206, 207) and
- conveying the heated coolant away from the racks (202), wherein
- the heat exchanging means are coupled individualy to the cooling circuit and can be separately and/or autonomously regulated,
- the racks have an open rack architecture and
- the racks do not emit any warm air to the data centre.

## Revendications

1. Centre de traitement de données comportant au moins un premier étage, resp. plan (220) et un deuxième étage, resp. plan (222), dans lequel les étages (220, 222) sont configurés comme des magasins à rayonnages et contiennent une pluralité d'étagères (202), dans lequel chaque espace de stockage individuel contient un matériel informatique (101), dans lequel le centre de traitement de données présente en outre un premier circuit de refroidissement, pour évacuer la chaleur produite par le matériel informatique (101) et dans lequel le premier circuit de refroidissement est conçu afin d'alimenter toutes les étagères (202) avec un fluide de refroidissement, dans lequel le premier circuit de refroidissement est en outre conçu afin d'évacuer le refroidissement réchauffé de ces étagères (202), **caractérisé en ce que** lesdites étagères (202) présentent des dispositifs d'échangeurs thermiques (206, 207), qui sont conçues afin de transmettre la chaleur produite au fluide de refroidissement, dans lequel les dispositifs d'échangeurs thermiques (206, 207) sont dimensionnés de telle sorte que par l'intermédiaire de ceux-ci la quantité totale de chaleur produite par le matériel informatique (101) puisse être évacuée, de sorte que pendant le fonctionnement aucune perte thermique sur le centre de traitement de données n'est émise par la pluralité d'étagères (202) et chaque étagère présente un couplage individuel au circuit de refroidissement et les étagères présentent une architecture d'étagère ouverte.

2. Centre de traitement de données selon la revendication 1, dans lequel le fluide de refroidissement est transporté dans le circuit de refroidissement avec une pression moindre que la pression atmosphérique.

3. Centre de traitement de données selon la revendication 2, dans lequel le premier circuit de refroidissement est conçu comme un circuit à dépression.

4. Centre de traitement de données selon une des revendications précédentes, dans lequel les étages, resp. plans (220, 222) n'ont pas de faux planchers.

5. Centre de traitement de données selon une ou plusieurs des revendications précédentes, présentant au moins un premier et un deuxième étage (220, 222), qui est appuyé sur une structure porteuse.

6. Centre de traitement de données selon la revendication 5, dans lequel des étagères (202) sont disposées directement sur des supports en T doubles de la structure porteuse, de préférence sur une structure porteuse en acier, et dans lequel des grilles (201) sont disposées dans les zones d'espacement entre des étagères (202) voisines localisées.

7. Centre de traitement de données selon une ou plusieurs des revendications précédentes, dans lequel se trouvent des étagères (202), qui présentent des unités d'échangeurs thermiques (206), qui sont conçues de manière à transmettre la chaleur entre un fluide de refroidissement et un fluide caloporteur gazeux, de préférence les unités d'échangeurs thermiques (206) et/ou ventilateurs (207) d'étagères (202) adjacentes installées par paires se font face par leurs côté avant.

8. Centre de traitement de données selon une ou plusieurs des revendications précédentes, dans lequel au moins quelques-unes des étagères (202) présentent des dispositifs de contrôle pour commande individuellement les dispositifs d'échangeurs thermiques (206, 207), de préférence les dispositifs de contrôle ont en outre (i) un détecteur de fuites pour le système de tubes (205), dans lequel ledit détecteur est branché à un système de secours, qui est conçu afin de mettre sous tension sélectivement le matériel (101), notamment spécifiquement à l'étagère, et/ou le circuit de refroidissement et/ou (ii) un détecteur de fumée, dans lequel ledit détecteur de fumée est branché à un système de secours, pour mettre sous tension sélectivement le matériel (101), notamment spécifiquement à l'étagère, et/ou le circuit de refroidissement.

9. Centre de traitement de données selon une ou plusieurs des revendications précédentes, dans lequel les étagères (202) présentent en outre un circuit d'enclenchement de courant, qui convient pour maintenir sous une limite prescrite le courant d'enclenchement électrique.

10. Centre de traitement de données selon une ou plusieurs des revendications précédentes, dans lequel en outre un deuxième circuit de refroidissement est prévu, qui est principalement de la même structure que le premier circuit de refroidissement, dans lequel les sections du système de tuyaux du premier et deuxième circuit de refroidissement sont disposés en alternance dans chaque rangée d'étagères (202).

11. Centre de traitement de données selon une quelconque des revendications précédentes 6 à 10, dans lequel le support en T double (203) sert de structure de guidage et d'appui pour un engin de levage (213, 212).

12. Centre de traitement de données selon une ou plusieurs des revendications précédentes, dans lequel un premier et/ou deuxième circuit de refroidissement est couplé à un accumulateur de chaleur externe.

13. Centre de traitement de données selon une ou plusieurs des revendications précédentes, dans lequel le premier et/ou le deuxième circuit de refroidissement sont couplés directement à une installation de chauffage d'un bâtiment séparé ou d'une unité de bâtiment, afin de les réchauffer, de préférence à 17°C et plus.

14. Utilisation d'une étagère pour matériel informatique (101) dans un centre de traitement de données selon une ou plusieurs des revendications précédentes 1 à 13, dans laquelle l'étagère présente un espace de stockage pour du matériel informatique (101) et des dispositifs d'échangeurs thermiques (206, 207), qui sont conçus afin de transmettre au fluide de refroidissement et évacuer la chaleur totale produite par le matériel informatique (101), de sorte que pendant le fonctionnement de l'étagère (202) aucun rejet thermique ne soit émis sur le centre de traitement de données et chaque étagère présente un couplage individuel au circuit de refroidissement et les étagères présentent une architecture d'étagère ouverte.

15. Procédé de refroidissement de la structure d'un centre de traitement de données, qui comprend une pluralité d'étagères (202) dans un magasin à rayonnages, desquelles chacun contient un espace de stockage pour du matériel informatique (101), qui produit de la chaleur, comportant les étapes suivantes :
- transporter un fluide de refroidissement vers l'étagère à l'aide d'un premier circuit de refroidissement,
- transmettre la chaleur totale produite dans l'étagère par le matériel informatique (101) au fluide de refroidissement au moyen de dispositifs d'échangeurs thermiques (206, 207) et
- transporter le fluide de refroidissement réchauffer loin de l'étagère (202), dans lequel
- les dispositifs d'échangeurs thermiques sont couplés individuellement au circuit de refroidissement et peuvent être régulés séparément et/ou de manière autonome,
- les étagères présentent une architecture ouverte d'étagère et
- les étagères n'émettent aucun rejet thermique vers le centre de traitement de données.
